Europäisches Patentamt

**European Patent Office**

**Office européen des brevets**

(19)

(11) Publication number: **0 091 201**

**A1**

(12) ## EUROPEAN PATENT APPLICATION

(21) Application number: **83301235.4**

(22) Date of filing: **08.03.83**

(51) Int. Cl.³: **H 03 D 9/04**
**H 03 L 7/04**

(30) Priority: **01.04.82 GB 8209740**

(43) Date of publication of application:
**12.10.83 Bulletin 83/41**

(84) Designated Contracting States:
**AT BE CH DE FR GB IT LI LU NL SE**

(71) Applicant: **BRITISH TELECOMMUNICATIONS**
**2-12 Gresham Street**
**London EC2V 7AG(GB)**

(72) Inventor: **Gosling, Ian Gilbert**
**29 Buttercup Close**
**Ipswich Suffolk IP8 3RG(GB)**

(74) Representative: **Smith, Norman Ian et al,**
**F.J. CLEVELAND & COMPANY 40-43 Chancery Lane**
**London WC2A 1JQ(GB)**

(54) **Microwave discriminator.**

(57) A microwave discriminator has a mixer 14 with two parallel input paths 12, 15 one 12 of which includes a dielectric resonator 13. After filtering out a microwave component, the output of the mixer 14 is a low frequency signal which measures the discrepancy between the input and a standard set by the resonator. The standard does not vary much with the temperature of the resonator. The discriminator can be used to improve the frequency stabilities of microwave devices, e.g. microwave oscillators.

FIG.5

MICROWAVE DISCRIMINATOR

This invention relates to a microwave discriminator. Microwave devices, e.g. radios, are usually implemented as wave guides including other components, e.g. active components. The device operates at a frequency dependent on its dimensions. Since the dimensions change with temperature the frequency of the device is also affected by temperature. An exception is a dielectric resonator in which the resonance frequency also depends on properties of ther dielectric.

A microwave discriminator according to the invention comprises a mixer with parallel input paths one of which includes a resonator. A microwave device is designed for operation at a particular frequency (hereinafter called the "standard frequency") and the resonator is adjusted so that its maximum resonance occurs at this standard frequency. The output of the mixer is dependent on the interaction between the unmodified signal and the signal as modified by the resonator and it is in the form of microwave frequencies superimposed upon a low frequency signal chasracteristic of the interaciton. For most applications it is desirable to remove the microwave component and the output of the mixer preferably includes a low pass filter to achieve this.

The operation of the device is as follows. The resonator changes the phase of the signal. The change of phase is dependent on the frequency and, in the operational range of the resonator, the change of phase is proportional to the difference between the received frquency and the standard frequency. The mixer receives two inputs which have the same frequency and produces an output consisting of several microwave components plus a low frequency component related to the difference of phase between the two inputs. The overall effect is that a discriminator according to the invention constitutes a frequency standard which generates a low frequency output which gives an accurate indication of the departure of the frequency of the signal from an accurately defined standard. The invention includes the use of the device to stabilise an oscillator by using the low frequency output as negative feedback and also the use of the device as a frequency demodulator.

The invention will now be described by way of example with reference to the accompanying drawings in which

Figure 1 is a diagram showing the important paths of a device according to the invention.

Figures 2A and 2B are graphs shoowing the low frequency output plotted against the frequency of the input.

Figure 3 is a diagram incorporating the paths of Figure 1 and also including extra paths to adjust the origin of the amplitude.

Figure 4 is a block diagram showing a device as illustrated in Figure 3 incorporated in a feedback loop to stabilize a microwave oscillator.

Figure 5 illustrates a microstrip realisation of Figure 1.

Figure 6 illustrates another microstrip realisation of Figure 1, and

Figure 7 illustrates a microstrip realisation of Figure 3.

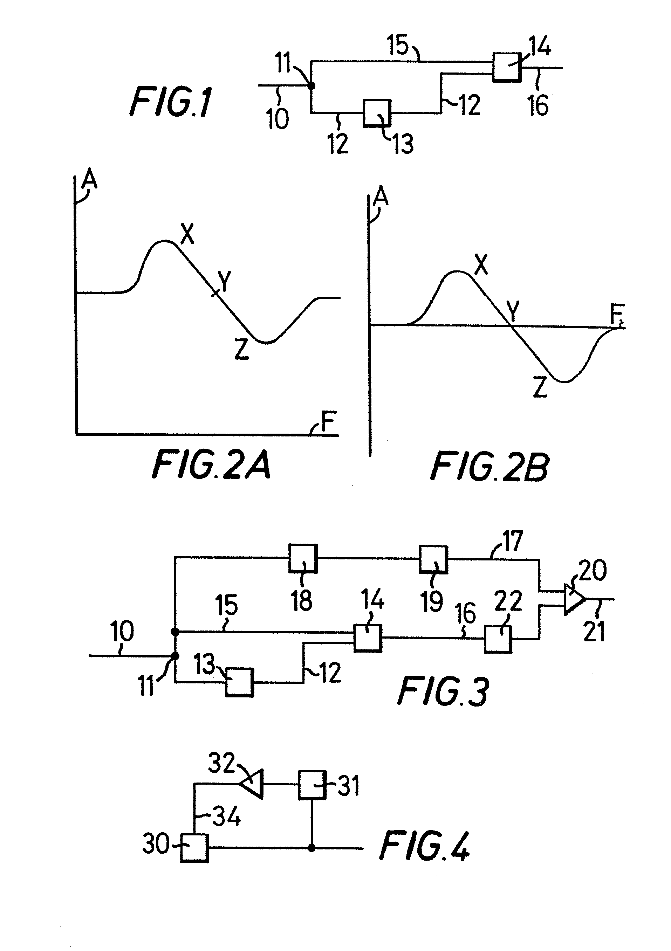

Figure 1 shows the paths included in a discriminator according to the invention. Figure 1 does not indicate how to implement the paths but embodiments utilising wave guides and/or microstrips and/or other transmission structures are all suitable.

The device illustrated in Figure 1 receives microwave input via an input path 10 which bifurcates at a node 11 into a direct path 15 and a primary path 12 which includes a dielectric resonator 13. Both of the paths 12 and 15 enter a mixer 14 which produces output on the output path 16.

The resultant consists of high frequency components together with a low frequency component and it is the low frequency component which constitutes the useful output of the discriminator. If the high frequencies have adverse effects they can be removed by a suitable filter. The low frequency component is determined by the phase angle between the two signals entering the mixer 14 and the phase angle can be regarded as the sum of two components, namely a nearly fixed angle related to the lengths of the paths and a variable angle produced by the resonator and related to the frequency of the signal in paths 12 and 15. A particularly useful result is obtained when the fixed angle is 90° and Figure 2A is a graph which indicates the nature of this relationship. The axes of the graph are A, which represents the amlplitude of the output, and F, which represents the frequency of the input. Attention is directed to that portion of the curve designated as XYZ. The portion of the curve is substantially linear and for most applications it is preferred to operate within this portion of the curve. If the frequency corresponding to Y is regarded as a standard the value of A serves as a measurement of the departure of the frequency from the standard.

The curve shown in Figure 2A can be regarded as the sum of an "error curve" and a constant. The "error curve" relates the difference between the frequency of the input and a standard corresponding to Y to the amplitude of the output. The constant is related to the amplitude of the input. It is usually desirable to subtract the constant to obtain the curve shown in Figure 2B in which the point Y has zero output. Figure 3, which is an extended version of Figure 1, illustrates a discriminator suitable for this purpose.

The device shown in Figure 3 includes the mixer 14 which receives input from path 15 and the resonator 13 as illustrated in Figure 1. The output from the mixer 14 passes to a filter which removes the microwave component and the output from filter 22 passes as one input to a subtracting amplifier 20. The other input to amplifier 20 is via path 17 which includes a detector 18 and a filter 19. The output of amplifier 20, on path 21, constitutes the output of the device.

In the use of the device, the signal in path 16 is the sum of the amplitude and an error signal whereas the signal in path 17 is just the amplitude. The amplifier 20 subtracts the two so that path 21 contains only the error signal. In a further modification, not shown in any drawing, a dividing amplifier is also incorporated to divide the error signal by the amplitude of the input. This gives an output solely dependent on the frequency of the input and, therefore such a modification is suitable for use as a frequency demodulator.

Figure 4 is a block diagram indicating how the device of Figure 3 can be used to stabilise a microwave oscillator. The arrangement comprises a microwave oscillator 30 the frequency of which is adjustable by the voltage on control lead 34. The frequency of the oscillator is controlled by means of a feedback loop which includes a discriminator 31 and an amplifier 32; the discriminator 31, which is the same as the device illustrated in Figure 3, is adjusted so that the control point Y of Figure 2 corresponds to desired frequency. If the oscillator 30 wanders from this set frequency, e.g. by reason of changes in temperature, a control signal is generated by the discriminator 31. After amplification this signal is fed to the control lead 34 to return the oscillator closer to the set frequency.

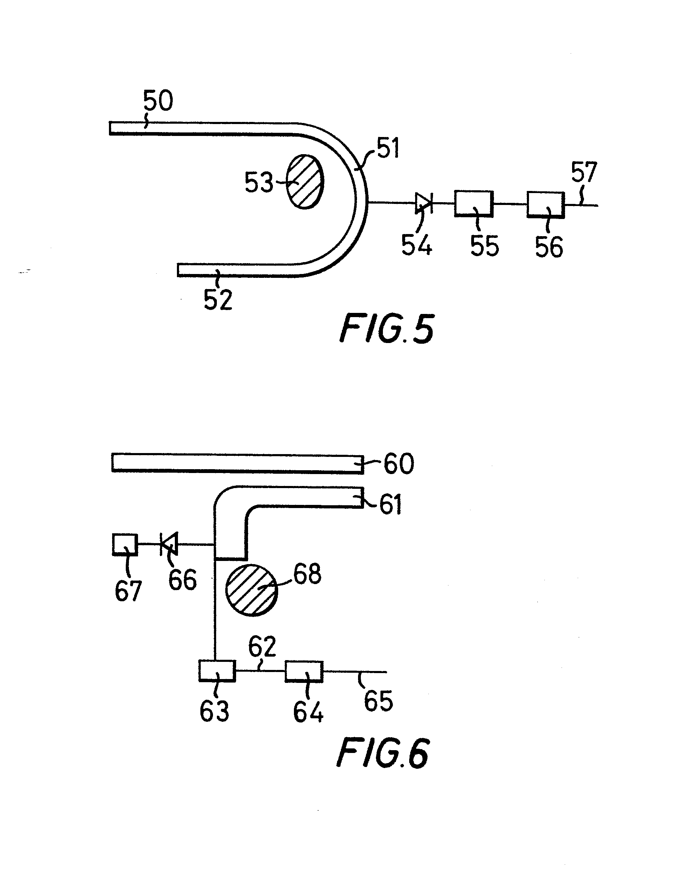

Figure 5 illustrates a microstrip implementation of the device shown in Figure 1. It consists of metal conductive layers on each side of a dielectric substrate; the drawing primarily shows the pattern on the obverse side of th substrate.  The
obverse pattern comprises a U-shaped strip of metal
having a primary arm 50 opposite a secondary arm 52
which is joined to the primary arm 50 via a quadrant
51.  The apex of the U is connected to rectangular
areas 55 and 56 by means of a diode 34.  The
rectangles 55 and 56 constitute a filter.  The length
(i.e. in the direction of the path) of each rectangle
is a nominal quarter wave length.  The width is not
critical.

A ceramic block 53 is positioned between the
arms of the U.  This constitutes a dielectric
resonator.  The reverse side of the device (not shown
in any drawing) is almost completely covered with a
conductive layer.  The only uncovered part is
opposite the area 53.

The paths provided by the device of Figure 5
correspond to those of Figure 1 as follows.  The arm
50 constitutes the input path 10 and the diode 54
constitutes the mixer 14.  The primary path 12 passes
via the ceramic block, i.e. the resonator, to the arm
52 and hence to the diode 54.  The direct path 15 is
provided by the quadrant  51.  As already stated the
filter, 55 and 56 of Figure 5, is not shown in Figure
1.  The device shown in Figure 5 operates in
accordance with the explanation given in respect of
Figure 1.

Figure 6 shows an alternative microstrip
realisation of the paths shown in Figure 1.  As with
Figure 5 it consists of metal conductive layers on
each side of a dielectric substrate; only the obverse
face is illustrated.

The pattern on the obverse face comprises a conductive region 60 near a secondary area 61 which is connected to an earth-region 67 by a diode 66. The secondary area 61 is also connected to the output 65 via line 62 which includes a filter having elements 63 and 64. A ceramic block 68, which constitutes a dielectric resonator, is adjacent to secondary areas 61 and line 62. The reverse side is a conductive area which is complete, except for the area opposited 68. The paths provided by the device of Figure 6 correspond to the paths of Figure 1 as follows.

Rectangle 60 constitutes the input path 10 and the diode 66 constitutes the mixer 14. The primary path 12 passes via the ceramic block 68 and the line 62 to the mixer 66. The direct path 15 is via secondary area 61 to the mixer 66. The output 65 passes via filter 63, 64 not shown in Figure 1. The operation is as described for Figure 1.

It is desired to emphasise one feature which is common to the implementations of Figures 5 and 6, i.e. a relationship between paths 12 and 15 of Figure 1 as defined above. The lengths of these paths are such that they cause a fixed phase difference of 90° (or 90° plus a whole number of periods) and this fixed difference is added (or subtracted) to the variable difference caused by the reasonator (53 in Figure 5 and 68 in Figure 6). It is necessary for the paths to be in correct adjustment for the output to conform to Figure 2B.

There is an interesting distinction between Figures 5 and 6 in the arrangement of the mixer, i.e. the diode 54 as compared with the diode 66.

Diode 54 is a single-ended series mixer whereas Diode 66 is a simple-ended shunt mixer. It is emphasised that both series and shunt configurations give effective results.

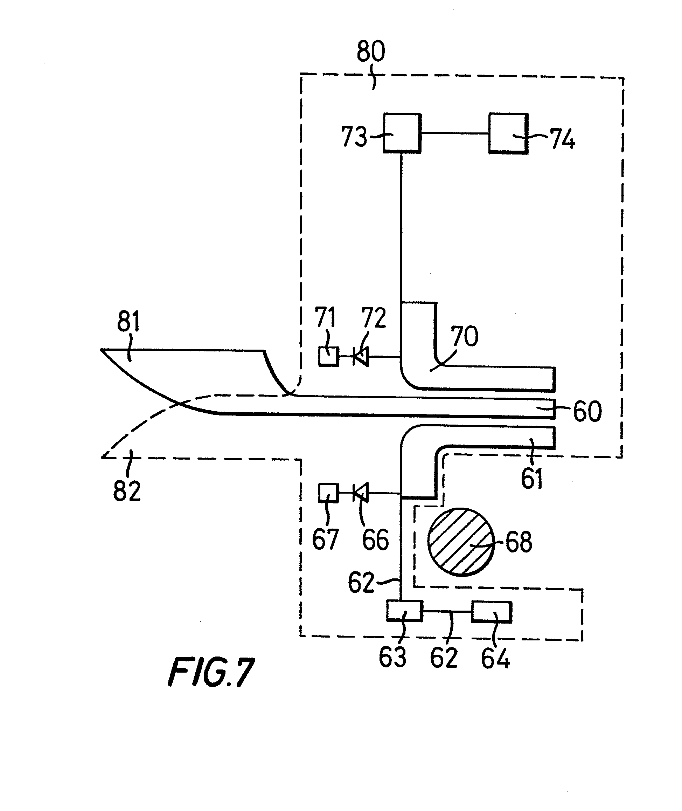

Figure 7 shows a microstrip realisation of the paths shown in Figure 3; this realisation includes the realisation shown in Figure 6. The continuous line indicates regions on the obverse whereas the dotted line indicates regions on the reverse.

The realisation comprises a pick-up strip 81 on the obverse which co-operates with a pick-up strip 82 on the reverse; this is a conventional arrangement to change wave guide transfer to microstrip transfer. The pick-up strip 81 is part of a single conductive region with an input strip 60 which forms an input to a discriminator in the lower part of Figure 7. This discriminator is the same as that shown in Figure 6 an its parts are numbered to conform. The upper part of Figure 7 constitutes a detector which comprises primary region 70 connected to an earth region 71 via a diode 72. The primary region 70 is also connected to a microwave filter formed of nominal quarter wave elements 73 and 74. Thus the device illustrated in Figure 7 includes two circuits which operate independently but have a common input 60 which is adapted to receive microwave signal from a wave guide at 81 (obverse) and 82 (reverse). The discriminator part of the device produces low frequency output at 64 and the output is a function of the power and frequency of the input. The detector part of the device produces an output at 74 which is a function of the power of the input. a subtracting amplifier, not shown in Figure 7, having one input connected to 74 and the other input connected to 64 implements the arrangement illustrated in Figure 3.

In Figures 5, 6 and 7 the mixer is formed of a single diode. More complicated mixers could be used, e.g. a balanced mixer with two diodes or a double balanced mixer with four diodes. These more complicated mixers give zero output when their two inputs have the same frequency and are in phase. Thus a more complicated mixer provides an alternative to the subtracting amplifier.

As stated above the output of the amplifier indicates the frequency of the input, i.e. the output is proportional to the divergence of the frequency of the input from a standard set by ceramic 68. The resonance frequency of the ceramic 68 is almost independent of temperature and hence the standard frequency is substantially independent of temperature. Thus the device shown in Figure 7 can be used as shown in Figure 3, to provide negative feedback to an oscillator which is sensitive to variations of temperature so that its sensitivity to temperature is compensated.

As explained above the ceramics utilised in the resonator are chosen by reference to their temperature coefficient. suitable ceramics include those based on mixtures of barium oxide and titanium oxide, the mole ratio determines the temperature coefficient and ratios of (BaO): (Ti)2) of 2:9 are suitable. Ceramics based on titanium oxide, zirconium oxide, tin oxide and other substances are also suitable.

- 1 -

0091201

## CLAIMS

1. A microwave discriminator characterised by comprising a mixer (14) with parallel input paths (12, 15) one (12) of which includes a dielectric resonator (13) whereby the output of the mixer is dependent on the frequency of a microwave input signal.

2. A discriminator according to claim 1 characterised by including a filter (22) in the output of the mixer (14) whereby the output thereof is a low frequency signal dependent on the frequency of the input.

3. A discriminator according to claim 2 charcterised by including a detector (18) for producing a signal representing the power of the input and a subtracting amplifier (20) for producing a signal dependent on the algebraic difference between the output of the mixer (14) and the detector (18).

4. A microwave discriminator according to claim 1 characterised in that it is implemented as microstrip in the form of conductive regions on both sides of a dielectric sheet.

5. A stabilised microwave oscillator having a feedback loop (31, 32) characterised in that the feedback loop includes a discriminator (31) according to any one of claims 1 to 4.

FIG.1

FIG.2A

FIG.2B

FIG.3

FIG.4

0091201

50

53    51

57

54    55    56

52

*FIG.5*

60

61

67    66    68

62

63    64    65

*FIG.6*

FIG.7

European Patent
Office

**EUROPEAN SEARCH REPORT**

**0091201**
Application number

EP 83 30 1235

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | PATENTS ABSTRACTS OF JAPAN, vol. 5, nr. 149, 19 September 1981, page 821-E-75 & JP-A- 56 83103 (SONY K.K.), 07-07-1981 * The whole document * | 1,2,4 5 | H 03 D    9/04 H 03 L    7/04 |
| X | PATENTS ABSTRACTS OF JAPAN, vol. 5, no. 82, 29 May 1981, page 754-E-59 & JP-A- 56 30305 (SONY K.K.), 26-03-1981 * The whole document * | 1,2,4 | |
| A | US-A-3 867 706 (GILI) * Figure 1, claim 1 * | 3,5 | |

TECHNICAL FIELDS
SEARCHED (Int. Cl. ³)

H 03 D
H 03 L

The present search report has been drawn up for all claims

| Place of search THE HAGUE | Date of completion of the search 22-06-1983 | Examiner VAN DER PEET H. |
|---|---|---|